# EUROPEAN PATENT APPLICATION

(11) **EP 4 783 237 A1**
(43) Date of publication of application: **29.07.2026**
(21) Application number: 24868038.1
(22) Date of filing: 27.08.2024
(51) Int. Cl.: H01L 23/28, B29C 43/18, B29C 43/34, H01L 21/56

(54) **COMPRESSION MOLDING DEVICE AND COMPRESSION MOLDING METHOD**

(30) Priority: 22.09.2023 JP 2023158401
(71) Applicant: Yamaha Robotics Co., Ltd., Musashimurayama-shi, Tokyo 208-8585 (JP)
(72) Inventor: WAKUI, Masaaki, Chikuma-shi, Nagano 389-0898 (JP); KAWAGUCHI, Makoto, Chikuma-shi, Nagano 389-0898 (JP)
(74) Representative: Becker, Eberhard
(86) International application number: PCT/JP2024/030348
(87) International publication number: WO 2025/062958

(57) **Abstract**

The present invention addresses the problem of providing a compression molding device and a compression molding method that are capable of preventing the occurrence of molding defects caused by scattering unevenness, residual gas, and dust generation during molding, and that are capable of preventing the formation of thin burrs of a sealing resin at an exposed portion of a molded product. As a solution, provided is a compression molding device (1) that processes a workpiece (W) into a molded product (Wp) by sealing the workpiece (W) with a sealing resin (R) by using a sealing mold (202) provided with a first mold (204) and second mold (206) of which one serves as an upper mold and the other serves as a lower mold. The sealing resin (R) is formed into a lattice shape having through holes (Rh). The first mold (204) has a cavity (208) configured as a recess having bottom sections formed by cavity pieces (226). The second mold (206) includes a workpiece holding part (205) that holds the workpiece (W).

## Description

### Technical Field

The invention relates to a compression molding device and a compression molding method.

### Related Art

As an example of a resin sealing device and a resin sealing method for sealing a workpiece having electronic parts mounted on a base material with sealing resin and processing the workpiece into a molded product, a compression molding method is known.

The compression molding method is a technology for resin sealing by supplying a predetermined amount of sealing resin to a sealing region (cavity) provided in a sealing mold configured to include an upper mold and a lower mold, placing a workpiece in the sealing region, and clamping with the upper mold and the lower mold. As an example, in the case of using a sealing mold having a cavity provided in the upper mold, a technology for supplying sealing resin collectively to a center position on the workpiece and molding is known. On the other hand, in the case of using a sealing mold having a cavity provided in the lower mold, a technology for supplying a release film (hereinafter, may be simply referred to as "film") covering the mold surface including the cavity and sealing resin and molding is known (see Patent Document 1: International Publication WO2015/159743).

### Citation List

### Patent Document(s)

[Patent Document 1] Patent Document 1: International Publication WO2015/159743

### SUMMARY OF INVENTION

### Technical Problem

Conventionally, it is also considered that there is an advantage from the perspective of preventing deformation of the workpiece caused by flow or contact of the sealing resin, and a compression molding method in which the workpiece is held in the upper mold, a cavity is provided in the lower mold, and sealing resin (as an example, granular resin) is supplied into the cavity is widely adopted.

However, in a configuration in which the workpiece is held in the upper mold and a cavity is provided in the lower mold, there is an issue that when the workpiece is thin or large, it is difficult to hold the workpiece and the workpiece may drop easily. In addition, when granular resin is used as the sealing resin, in addition to the issue that dust is generated during molding due to the friction between resin particles and the issue that handling is difficult, there is an issue that it is difficult to supply (scatter) the sealing resin uniformly to the entire region within the cavity provided in the lower mold, and uneven scattering tends to occur. In addition, there is an issue that molding defects tend to occur in which air contained in gaps between particles during scattering of the sealing resin and gas components due to degassing from the sealing resin during melting remain as voids or the like in the molded product without escaping.

On the other hand, regardless of the arrangement of the cavity, for example, in the case of forming a molded product in which electronic parts, such as a heat dissipation plate or flip-chip connected chips, are exposed, there is an issue that thin burrs of the sealing resin tend to be formed on the exposed portion of the molded product (as a specific example, the upper surface of the electronic part), resulting in incomplete exposure.

### Solution to Problem

The invention has been made in view of the above circumstances, and an object thereof is to provide a compression molding device and a compression molding method capable of preventing molding defects caused by uneven scattering, residual gas, and dust generation during molding from occurring, and capable of preventing thin burrs of sealing resin on an exposed portion of a molded product from being formed.

The invention solves the above issues by means of solutions as described below as an embodiment.

Sealing resin according to one embodiment is a compression molding device that seals a workpiece with sealing resin and processes the workpiece into a molded product by using a sealing mold including a first mold and a second mold, one of which serves as an upper mold and the other serves as a lower mold. The sealing resin is formed in a lattice shape having a through hole. The first mold has a cavity configured as a recess in which a cavity piece forms a bottom part. The second mold has a workpiece holding part that holds the workpiece.

In addition, it may also be configured that the sealing resin is solid resin formed by tableting powder resin, or sheet-shaped resin.

In addition, it may also be configured that the first mold further has a movable piece that is arranged at a position corresponding to the through hole of the sealing resin on an inner side of the cavity and is movable up and down, and when the sealing mold is closed, the movable piece enters the through hole and comes into contact with an upper surface of the workpiece.

In addition, it may also be configured that the workpiece has a configuration in which an electronic part is mounted on a base material, the sealing resin has a configuration in which a heat dissipation plate is fixed and the through hole is blocked, and a member having elasticity and thermal conductivity is provided between a surface of the electronic part of the workpiece opposite to the heat dissipation plate and a surface of the heat dissipation plate of the sealing resin placed on the workpiece or an inner side of the cavity opposite to the electronic part.

In addition, a compression molding method according to an embodiment is provided for sealing a workpiece with sealing resin and processing the workpiece into a molded product by using a sealing mold including a first mold and a second mold, one of which serves as an upper mold and an other serves as a lower mold. The compression molding method includes: adopting sealing resin formed in a lattice shape having a through hole as the sealing resin; a workpiece holding process of holding the workpiece in the second mold; a resin placement process of placing the sealing resin on the workpiece in a case where the first mold is an upper mold, and placing the sealing resin on an inner side of a cavity of the first mold in a case where the first mold is a lower mold; and a mold closing process of performing mold closing of the sealing mold to seal the workpiece with the sealing resin and process the workpiece into the molded product.

### Effects of Invention

According to the compression molding device and the compression molding method according to the invention, it is possible to prevent molding defects caused by scattering unevenness, residual gas, and dust generation during molding from occurring, and it is possible to prevent thin burrs of sealing resin at an exposed portion of the molded product from being formed.

### BRIEF DESCRIPTION OF DRAWINGS

[FIG. 1] FIG. 1 is a plan view showing an example of a compression molding device according to an embodiment of the invention.
[FIG. 2] FIG. 2 is a side view showing an example of a press device of a compression molding device according to a first embodiment of the invention.
[FIG. 3] FIG. 3 is a front cross-sectional view showing an example of a sealing mold of the compression molding device according to the first embodiment of the invention.
[FIG. 4] FIG. 4 is an explanatory view describing an example of a compression molding method using the compression molding device including the press device shown in FIG. 2 and the sealing mold shown in FIG. 3.
[FIG. 5] FIG. 5 is an explanatory view following FIG. 4.
[FIG. 6] FIG. 6 is an explanatory view following FIG. 5.
[FIG. 7] FIG. 7 is an explanatory view following FIG. 6.
[FIG. 8] FIG. 8 is an explanatory view following FIG. 7.
[FIG. 9] FIG. 9 is an explanatory view following FIG. 8.
[FIG. 10] FIG. 10 is a front cross-sectional view showing another example of the sealing mold of the compression molding device according to the first embodiment of the invention.
[FIG. 11] FIG. 11 is an explanatory view describing an example of a compression molding method by the compression molding device including the press device shown in FIG. 2 and the sealing mold shown in FIG. 10.
[FIG. 12] FIG. 12 is an explanatory view following FIG. 11.
[FIG. 13] FIG. 13 is an explanatory view following FIG. 12.
[FIG. 14] FIG. 14 is an explanatory view following FIG. 13.
[FIG. 15] FIG. 15 is a side view showing an example of a press device of a compression molding device according to a second embodiment of the invention.
[FIG. 16] FIG. 16 is a front cross-sectional view showing an example of a sealing mold of the compression molding device according to the second embodiment of the invention.
[FIG. 17] FIG. 17 is an explanatory view describing an example of a compression molding method by the compression molding device including the press device shown in FIG. 15 and the sealing mold shown in FIG. 16.
[FIG. 18] FIG. 18 is an explanatory view following FIG. 17.
[FIG. 19] FIG. 19 is an explanatory view following FIG. 18.
[FIG. 20] FIG. 20 is an explanatory view following FIG. 19.
[FIG. 21] FIG. 21 is an explanatory view following FIG. 20.
[FIG. 22] FIG. 22 is an explanatory view following FIG. 21.
[FIG. 23] FIG. 23 is a front cross-sectional view showing another example of a sealing mold of a compression molding device according to a second embodiment of the invention.
[FIG. 24] FIG. 24 is an explanatory view describing an example of a compression molding method by the compression molding device including the press device shown in FIG. 15 and the sealing mold shown in FIG. 23.
[FIG. 25] FIG. 25 is an explanatory view following FIG. 24.
[FIG. 26] FIG. 26 is an explanatory view following FIG. 25.
[FIG. 27] FIG. 27 is an explanatory view following FIG. 26.
[FIG. 28] FIG. 28 is a perspective view showing an example of a workpiece to be a molded product in the compression molding device and the compression molding method according to an embodiment of the invention.
[FIG. 29] FIG. 29 is a perspective view showing an example of sealing resin used in the compression molding device and the compression molding method according to an embodiment of the invention.
[FIG. 30] FIG. 30 is a perspective view showing an example of a molded product subjected to compression molding using the sealing resin shown in FIG. 29.
[FIG. 31] FIG. 31 is a perspective view showing another example of sealing resin used in the compression molding device and the compression molding method according to an embodiment of the invention.
[FIG. 32] FIG. 32 is a perspective view showing an example of a molded product subjected to compression molding using the sealing resin shown in FIG. 31.

### DESCRIPTION OF EMBODIMENTS

### [First Embodiment]

A compression molding device 1 according to the embodiment is a device that performs resin sealing (compression molding) of a workpiece (product to be molded) W using a sealing mold 202 including a first mold (in the embodiment, an upper mold) 204 and a second mold (in the embodiment, a lower mold) 206. Hereinafter, as the compression molding device 1, a compression molding device will be described as an example in which the workpiece W is held by a workpiece holding part 205 provided in the lower mold 206, a cavity 208 (partially including a mold surface 204a) provided in the upper mold 204 in a corresponding arrangement is covered with a release film F, a clamping operation between the upper mold 204 and the lower mold 206 is performed, and the workpiece W is sealed with sealing resin R.

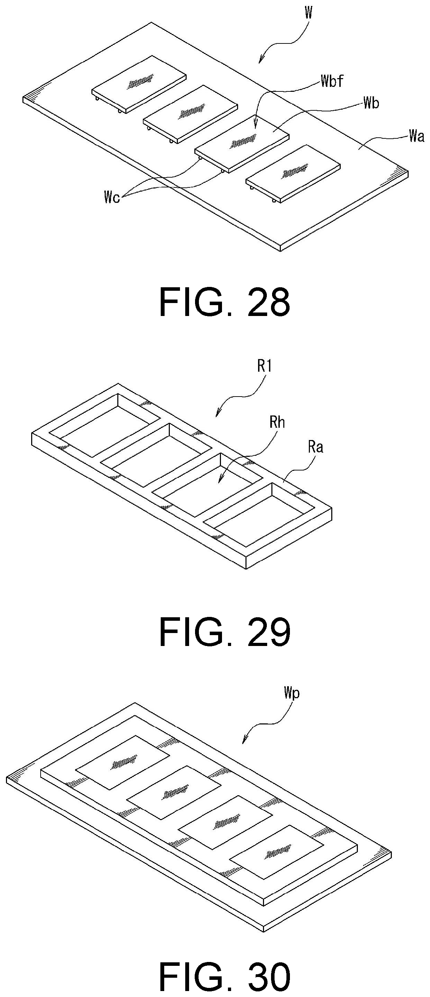

The workpiece W as the product to be molded has a configuration in which electronic parts Wb are mounted on a base material Wa (see FIG. 28). More specifically, examples of the base material Wa include plate-shaped members such as resin substrates, ceramics substrates, metal substrates, carrier plates, lead frames, and wafers. Also, examples of the electronic parts Wb include semiconductor chips, MEMS chips, passive elements, heat dissipation plates (heat sinks), conductive members, spacers, and coil sheets (the workpiece W may have a configuration consisting only of the electronic parts Wb). A general shape of the base material Wa is rectangular (strip-shaped), square, circular, or the like. Also, the number of electronic parts Wb mounted on one base material Wa is set to one or multiple.

Examples of a method for mounting the electronic parts Wb on the base material Wa include methods using flip-chip mounting, wire bonding mounting, and the like. Alternatively, in the case of a configuration in which the base material (a carrier plate made of glass or metal) Wa is peeled off from a molded product Wp after resin sealing, there is also a method of attaching the electronic parts Wb by using a thermally peelable adhesive tape or an ultraviolet curable resin that cures through ultraviolet irradiation. In the embodiment, a configuration in which the electronic parts Wb are flip-chip connected to the base material Wa via a bump Wc will be described as an example, but the invention is not limited thereto. Also, resin sealing may be performed while exposing a partial region of the base material Wa, and the electronic parts Wb may be mounted on the exposed portion after the resin sealing.

As the sealing resin R, a thermosetting resin (for example, a filler-containing epoxybased resin or the like, but the invention is not limited thereto) is used. The sealing resin R is formed as a solid resin having a predetermined shape in which the overall shape corresponds to the shape of the workpiece W. Normally, one piece constitutes the "entirety" of the required amount for sealing (one portion per workpiece W), but it may also be configured that the "entirety" of the required amount for sealing is constituted in a divided state of several pieces (for example, about two or three pieces).

The "predetermined shape" is a lattice-like shape that is substantially plate-shaped and has through holes Rh penetrating through the plate surface of a main body part Ra (see FIG. 29). Here, "lattice-like" in the present application is exemplified as a matrix shape including a single row shape, but the invention is not limited thereto. The predetermined shape may also be a matrix shape of multiple rows and multiple columns, a random shape, or the like. By performing resin sealing (compression molding) using the sealing resin R (hereinafter, may be referred to as "R1" for distinction), it is possible to prevent thin burrs on upper surfaces Wbf of the electronic parts Wb from being formed, and it is possible to form a molded product Wp in which the upper surface Wbf is reliably exposed (see FIG. 30) (details of the forming method will be described later). The through hole Rh is slightly larger in size than the individual electronic part Wb and needs to have the same shape as the electronic part Wb. Also, the resin amount (height) of the sealing resin R (R1) needs to be an amount such that the resin enters under the electronic part Wb and sealing can be performed without excess or deficiency.

Also, "solid" includes those that have melted to a so-called B-stage rather than a completely solid state, and those in a state immediately before melting. As the solid sealing resin R, a solid resin formed by tableting powder resin is preferably used. In this way, compared to tableted resin formed using granular resin or crushed resin, the resin amount can be adjusted and supplied extremely accurately. However, the configuration is not limited to powder resin, and may be a configuration in which granular resin, crushed resin, solid resin, liquid resin, or a resin combining multiple of these is used. Also, as the solid sealing resin R, sheet-shaped resin is also preferably used. By using the solid sealing resin R, compared to conventional granular resin, it is possible to solve the issue of dust generation during molding, the issue of difficult handling, and the issue of uneven scattering occurring easily. Also, since the occurrence of voids can be suppressed, mold underfill of flip-chip connected electronic parts Wb can be reliably performed in particular.

Also, as examples of the film F, film materials excellent in heat resistance, ease of peeling, flexibility, and extensibility are preferably used, for example, polytetrafluoroethylene (PTFE), polytetrafluoroethylene polymer (ETFE), PET, FEP, fluorine-impregnated glass cloth, polypropylene, polyvinylidene chloride, and the like.

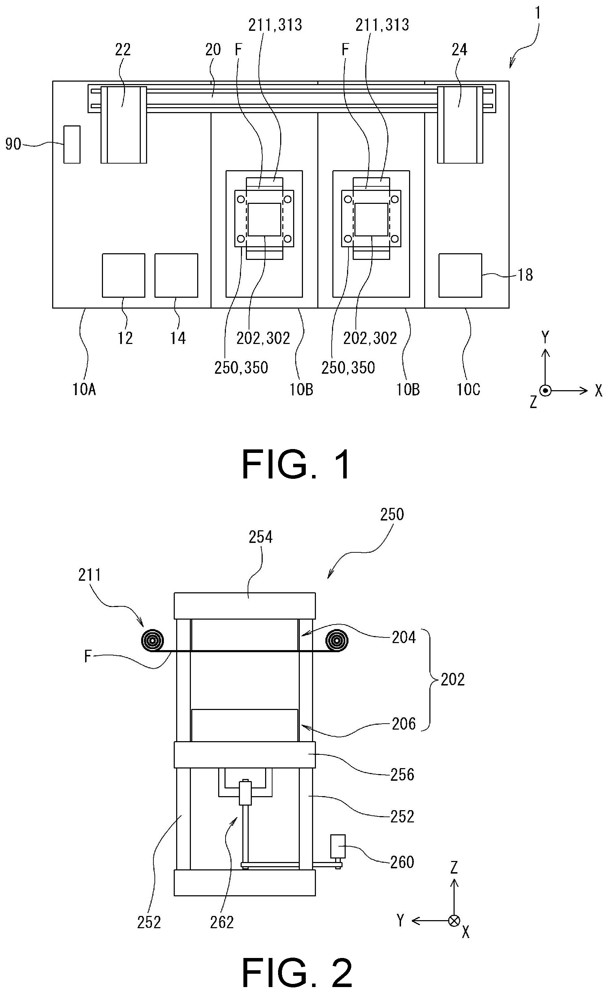

Next, an overview of the compression molding device 1 according to the embodiment will be described. As shown in FIG. 1, the compression molding device 1 includes, as main components, a supply unit 10A that performs supply of the workpiece W and the sealing resin R and the like, a press unit 10B that performs resin sealing of the workpiece W with the sealing resin R and processing into the molded product Wp and the like, and a storage unit 10C that performs storage of the molded product Wp and the like. As an example, the supply unit 10A, the press unit 10B, and the storage unit 10C are arranged in this order along X-direction in FIG. 1. However, the configuration is not limited to the above, and the equipment configuration within the units, the number of units, the arrangement order of the units, and the like may be changed. For example, the supply unit 10A and the storage unit 10C may be arranged in mutually opposite positions in X-direction, or may be arranged to be consolidated at either one of the positions (not shown). Also, a configuration including units other than the above may be employed (not shown).

Also, in the compression molding device 1, a guide rail 20 is provided linearly across the units, and a transport device (first loader) 22 that transports the workpiece W and the sealing resin R (may also be used for transporting items other than the workpiece W and the sealing resin R), and a transport device (second loader) 24 that transports the molded product Wp (may also be used for transporting items other than the molded product Wp) are provided movably between predetermined units along the guide rail 20. However, the configuration is not limited to the above, and a configuration including a common (single) transport device (loader) that transports the workpiece W, the sealing resin R, the molded product Wp, and the like may be employed (not shown). Also, the transport device may be configured to include a robot hand or the like instead of a loader.

Also, in the compression molding device 1, a control part 90 that performs operation control of each mechanism in each unit is arranged in the supply unit 10A (a configuration in which the control part is arranged in other units may also be employed).

### (Supply unit)

Next, the supply unit 10A included in the compression molding device 1 will be described in detail.

The supply unit 10A includes a workpiece supply magazine 12 in which multiple workpieces W are stored. Here, a conventional stack magazine, slit magazine, and the like is used for the workpiece supply magazine 12. The supply unit 10A may be configured to include a workpiece stage and the like (not shown) on which the workpiece W taken out from the workpiece supply magazine 12 is placed.

Also, the supply unit 10A includes a resin supply part 14 that supplies the sealing resin R. Here, a conventional stack magazine, a slit magazine, and the like is used for the resin supply part 14. The supply unit 10A may be configured to include a resin stage and the like (not shown) on which the sealing resin R taken out from the resin supply part 14 is placed. The resin supply part 14 may be configured to be arranged in the press unit 10B or the storage unit 10C (not shown). Alternatively, as another example, the resin supply part 14 may be configured to be arranged outside the compression molding device 1 and transported into the device using a transport device such as a belt conveyor or a robot hand (not shown).

The workpiece W and the sealing resin R are held by a first loader 22, transported into the press unit 10B, and set at a predetermined position of the sealing mold 202. In the embodiment, the workpiece W is held by the workpiece holding part 205 of the lower mold 206, and the sealing resin R is placed on the workpiece W held by the workpiece holding part 205 (details of the process will be described later). For the holding mechanism for the workpiece W and the sealing resin R in the first loader 22, a conventional holding mechanism (for example, a configuration that clamps with holding claws, a configuration that suctions with suction holes communicating with a suction device, and the like) may be used (not shown).

As a modification example of the transport device, instead of the first loader 22 that moves in X- and Y-directions, a configuration may be employed in which a transport device (loader) that moves in X-direction to perform transport between units and a transport device (loader) that moves in Y-direction to perform transport into the sealing mold 202 and setting in the sealing mold 202 are provided separately (not shown).

Also, the supply unit 10A includes a preheating heater (not shown) that performs preheating of the workpiece W and the sealing resin R. As an example, a conventional heating mechanism (for example, electric heating wire heaters, infrared heaters, and the like) are used for the preheating heater. This allows preheating to be performed before the workpiece W and the sealing resin R are transported into the sealing mold 202. A configuration without the preheating heater may also be employed. Also, instead of the preheating heater, or together with the preheating heater, a configuration in which the first loader 22 includes a heater for preheating (not shown) may be employed.

### (Press unit)

Next, the press unit 10B included in the compression molding device 1 will be described in detail.

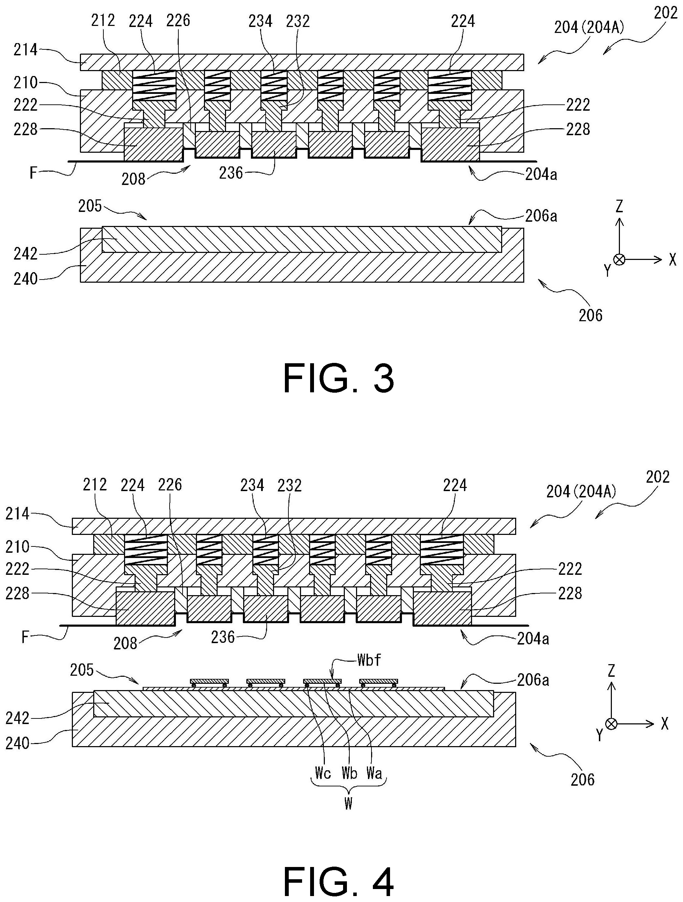

In the embodiment, two press units 10B are provided (three or more or one may also be employed). The press unit 10B includes a sealing mold 202 having a pair of molds that are opened and closed (for example, multiple mold blocks, mold plates, mold pillars, and other members assembled together, which are made of alloy tool steel). Also, the press unit 10B includes a press device 250 that drives the sealing mold 202 to open and close to perform resin sealing of the workpiece W. As an example, a configuration including one press device 250 is employed, but a configuration including multiple press devices 250 may also be employed (not shown). A side view (schematic view) of the press device 250 provided in the press unit 10B is shown in FIG. 2, and a front cross-sectional view (schematic view) of the sealing mold 202 is shown in FIG. 3.

Here, as shown in FIG. 2, the press device 250 is configured to include a pair of platens 254, 256, multiple tie bars 252 on which the pair of platens 254, 256 are installed, and a drive device that moves (raises and lowers) the platen 256. Specifically, the drive device is configured to include a drive source (for example, an electric motor) 260 and a drive transmission mechanism (for example, a ball screw or toggle link mechanism) 262 (however, the configuration is not limited thereto). In the embodiment, the platen 254 on the upper side in the vertical direction is set as a fixed platen (a platen fixed to the tie bars 252), and the platen 256 on the lower side is set as a movable platen (a platen slidably held by the tie bars 252 and raised and lowered). However, the invention is not limited thereto, and the arrangement may be reversed, that is, the upper side may be set as a movable platen and the lower side may be set as a fixed platen, or both the upper side and the lower side may be set as movable platens (none of which are shown).

On the other hand, as shown in FIG. 3, the sealing mold 202 includes a first mold (upper mold) 204 (204A) and a second mold (lower mold) 206 as a pair of molds arranged between the pair of platens 254, 256 in the press device 250. The upper mold 204 (204A) is assembled to the platen on the upper side (in the embodiment, the fixed platen 254), and the lower mold 206 is assembled to the platen on the lower side (in the embodiment, the movable platen 256). Mold closing and mold opening are performed by the upper mold 204 (204A) and the lower mold 206 approaching and separating from each other (the vertical direction (upper-lower direction) is the mold opening and closing direction).

In the embodiment, as an example, a film supply mechanism 211 is provided that transports (supplies) a roll-shaped film F into the interior of the sealing mold 202. The film F may be used in a strip shape instead of a roll shape depending on the configuration of the workpiece W.

Next, the lower mold 206 of the sealing mold 202 will be described in detail. As shown in FIG. 3, the lower mold 206 includes a second chase 240 and a second plate 242 held by the second chase 240.

In the embodiment, the workpiece holding part 205 is provided that holds the workpiece W at a predetermined position on the upper surface of the second plate 242. As an example, the workpiece holding part 205 includes a workpiece guide pin (not shown) and a suction path (hole, groove, etc.) that is arranged by penetrating through the second plate 242 and communicates with a suction device (not shown). Specifically, an end of the suction path leads to a mold surface 206a of the lower mold 206, and the other end is connected to a suction device arranged outside the lower mold 206. This makes it possible to drive the suction device to suction the workpiece W from the suction path and to hold the workpiece W by suctioning the workpiece W to the mold surface 206a (here, the upper surface of the second plate 242). Instead of the suction holding mechanism described above, or together with the suction holding mechanism, a configuration including holding claws that clamp the outer periphery of the workpiece W may be adopted (not shown). The shape and the number of the workpiece holding parts 205 provided in one lower mold 206 are appropriately set according to the shape and the number of the workpieces W (one or multiple).

In the embodiment, a lower mold heating mechanism (not shown) is provided that heats the lower mold 206 to a predetermined temperature. The lower mold heating mechanism includes a heater (for example, an electric heating wire heater), a temperature sensor, a power source, and the like, and heating control is performed by the control part 90. As an example, the heater is built into the second chase 240 and is configured to apply heat to the entire lower mold 206 and the workpiece W held by the workpiece holding part 205. The lower mold 206 is heated by the heater to a predetermined temperature (for example, 100°C to 300°C).

Next, the upper mold 204 (204A) of the sealing mold 202 will be described in detail. As shown in FIG. 3, the upper mold 204 (204A) includes a first chase 210 and a cavity piece 226, a clamper 228, and the like held by the first chase 210. The first chase 210 is fixed to the lower surface of the support plate 214 via a support pillar 212. A cavity 208 is provided on the lower surface (the surface on the side of the lower mold 206) of the upper mold 204 (204A).

The clamper 228 is configured in an annular shape so as to surround the cavity piece 226, and is assembled to be movable up and down by being spaced apart (floating) from the lower surface of the support plate 214 via a push pin 222 and a clamper spring (for example, a biasing member exemplified by a coil spring) 224 (however, the invention is not limited to the assembly structure). The cavity piece 226 constitutes the inner part (bottom part) of the cavity 208, and the clamper 228 constitutes the side part of the cavity 208. The shape and the number of the cavities 208 provided in one upper mold 204 (204A) are appropriately set (one or multiple) according to the shape and the number of the workpieces W.

Here, a movable piece 236 is provided on the cavity piece 226 (the inner side of the cavity 208) at a position corresponding to the through hole Rh of the sealing resin R (R1) held by the workpiece holding part 205. The movable piece 236 is supported in a state of being biased toward the lower mold 206 by a movable piece spring 234 via a push pin 232, and is configured to be movable in the mold opening and closing direction. In addition, as an example, the movable piece 236 is set to have an outer diameter that is larger than the outer shape of the electronic part Wb by a predetermined dimension in plan view. That is, the movable piece 236 is configured to enter the through hole Rh of the sealing resin R (R1) and contact the entire upper surface Wbf of the electronic part Wb during mold closing. This allows formation of the molded product Wp in which the upper surface Wbf of the electronic part Wb is exposed.

In addition, a suction path (hole, groove, and the like) communicating with a suction device is provided on the lower surface of the clamper 228, at the boundary between the clamper 228 and the cavity piece 226, and the like (not shown). This allows the film F supplied from the film supply mechanism 211 to be adsorbed and held on the mold surface 204a including the inner surface of the cavity 208. In addition, degassing inside the cavity 208 can be performed when mold closing is performed to carry out resin sealing.

In addition, in the embodiment, an upper mold heating mechanism (not shown) that heats the upper mold 204 (204A) to a predetermined temperature is provided. The upper mold heating mechanism includes a heater (for example, an electric heating wire heater), a temperature sensor, a power source, and the like, and heating control is performed by the control part 90. As an example, the heater is built into the first chase 210 and is configured to apply heat to the entire upper mold 204 (204A) and the sealing resin R accommodated in the cavity 208. The upper mold 204 (204A) is heated by the heater to a predetermined temperature (for example, 100°C to 300°C).

### (Storage unit)

Next, the storage unit 10C included in the compression molding device 1 will be described in detail.

The molded product Wp is held by the second loader 24, unloaded from the sealing mold 202, and transported to the storage unit 10C. For the holding mechanism of the molded product Wp in the second loader 24, a conventional holding mechanism (for example, a configuration that clamps with holding claws, a configuration that adsorbs with suction holes communicating with a suction device, and the like) is used (not shown).

As a modification example of the transport device, instead of the second loader 24 that moves in X- and Y-directions, a configuration may be adopted in which a transport device (loader) that moves in X-direction to perform transport between units and a transport device (loader) that moves in Y-direction to perform unloading from the sealing mold 202 are separately provided (not shown).

The storage unit 10C includes the storage magazine 18 in which multiple molded products Wp are stored. Here, for the storage magazine 18, a conventional stack magazine, slit magazine, or the like is used. The storage unit 10C may be configured to include a molded product stage or the like (not shown) on which the molded product Wp transported from the press unit 10B is placed.

### (Compression molding method)

Next, processes of the compression molding method according to the embodiment performed using the compression molding device 1 will be described. Here, FIG. 4 to FIG. 9 are explanatory diagrams of the respective process, and are illustrated as front cross-sectional views in the same direction as FIG. 3.

First, as a preparation process, a heating process (upper mold heating process) is performed in which the upper mold 204 (204A) is adjusted to a predetermined temperature (for example, 100°C to 300°C) and heated by the upper mold heating mechanism. Also, a heating process (lower mold heating process) is performed in which the lower mold 206 is adjusted to a predetermined temperature (for example, 100°C to 300°C) and heated by the lower mold heating mechanism. Also, a film supply process is performed in which the film supply mechanism 211 is operated to supply a new film F and adsorb it so as to cover a predetermined region of the mold surface 204a including the inner surface of the cavity 208 in the upper mold 204 (204A).

After the preparation process, a workpiece holding process is performed in which the workpiece W is held by the workpiece holding part 205 of the lower mold 206 (see FIG. 4). Specifically, the workpiece W supplied from the workpiece supply magazine 12 is held by the first loader 22, carried into the sealing mold 202, and held by the workpiece holding part 205 of the second plate 242 (mold surface 206a).

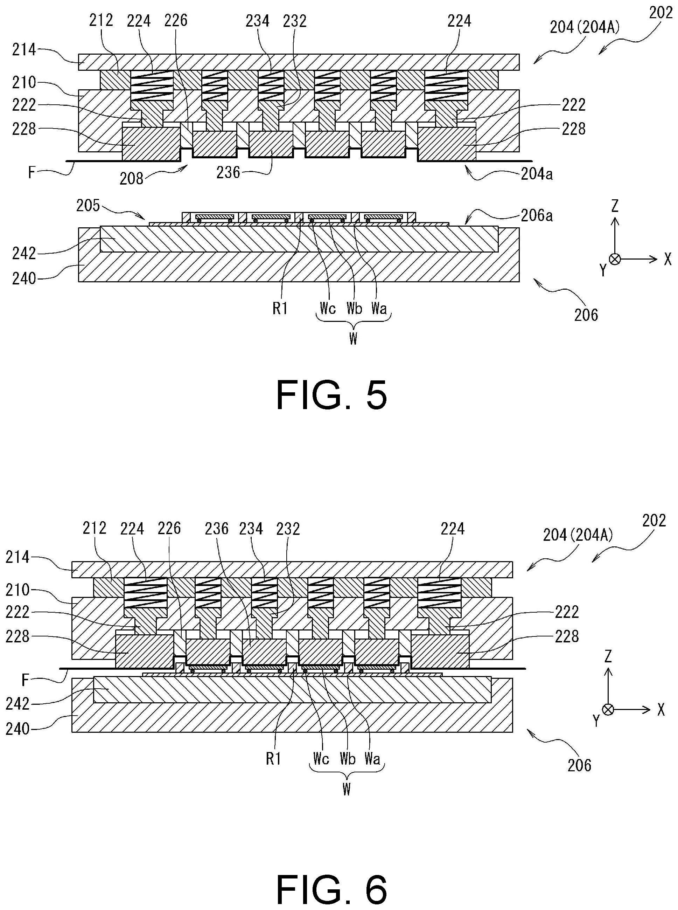

After the workpiece holding process, a resin placement process is performed in which the sealing resin R (R1) is placed on the workpiece W held by the workpiece holding part 205 (see FIG. 5). Specifically, the sealing resin R (R1) supplied from the resin supply part 14 is held by the first loader 22 (another transport device may also be used), carried into the sealing mold 202, and placed on the workpiece W held by the workpiece holding part 205. In the case of forming the molded product Wp in which the upper surface Wbf of the electronic part Wb is exposed, the workpiece W and the sealing resin R are mutually aligned and placed so that the electronic part Wb is accommodated in the through hole Rh of the sealing resin R (R1).

Alternatively, as another example of the resin placement process, it may also be performed as a process of placing the sealing resin R (R1) on the workpiece W before the workpiece holding process. In such case, the workpiece holding process becomes a process of holding, by the workpiece holding part 205, the workpiece W in a state where the sealing resin R (R1) is placed thereon. That is, the first loader 22 holds the workpiece W in a state where the sealing resin R (R1) is placed thereon, carries the workpiece W into the sealing mold 202, and holds the workpiece W by the workpiece holding part 205. In this case, there is an advantage that the workpiece W and the sealing resin R (R1) are carried into the sealing mold 202 at once rather than separately.

After the resin placement process, a mold closing process is performed in which the workpiece W is sealed with the sealing resin R (R1) and processed into the molded product Wp. Specifically, mold closing of the sealing mold 202 is performed, the cavity piece 226 is relatively lowered within the cavity 208 surrounded by the clamper 228, and the sealing resin R (R1) is heated and pressurized against the workpiece W.

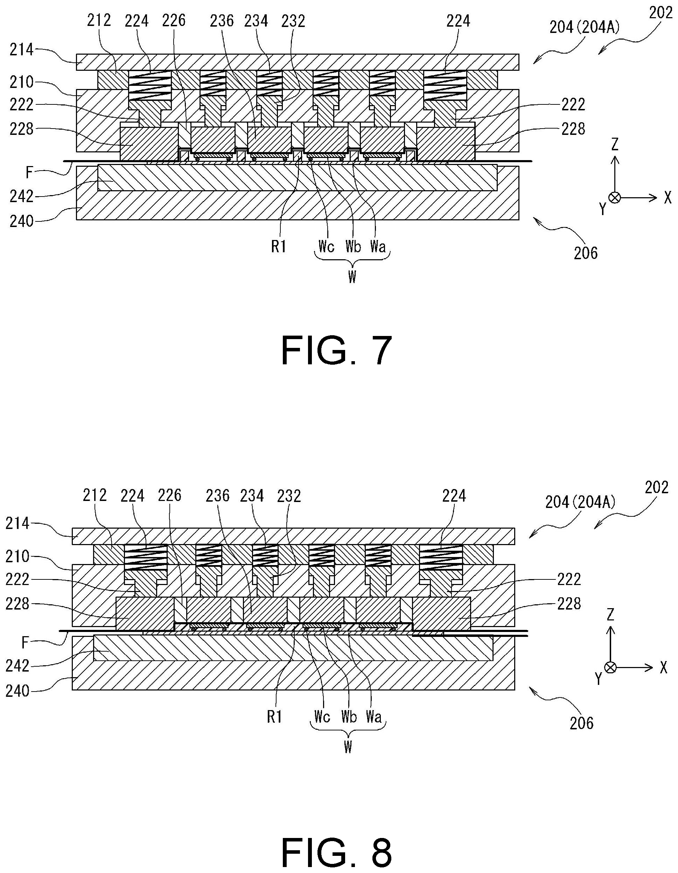

More specifically, an operation is performed to move the upper mold 204 (204A) and the lower mold 206 closer to each other. At this time, the movable piece 236 enters the through hole Rh of the sealing resin R (R1) and comes into contact with the upper surface Wbf of the electronic part Wb of the workpiece W and covers the entire upper surface Wbf (see FIG. 6). Next, the clamper 228 comes into contact with the base material Wa of the workpiece W via the film F and clamps the workpiece W is clamped (see FIG. 7). These may be set in the reverse order or to occur simultaneously. Next, the lower surface of the cavity piece 226 (the region where the movable piece 236 is not provided) comes into contact with and further pressurizes the sealing resin R (R1) placed on the base material Wa of the workpiece W. As a result, the sealing resin R (R1) is thermoset and resin sealing (compression molding) is completed (see FIG. 8).

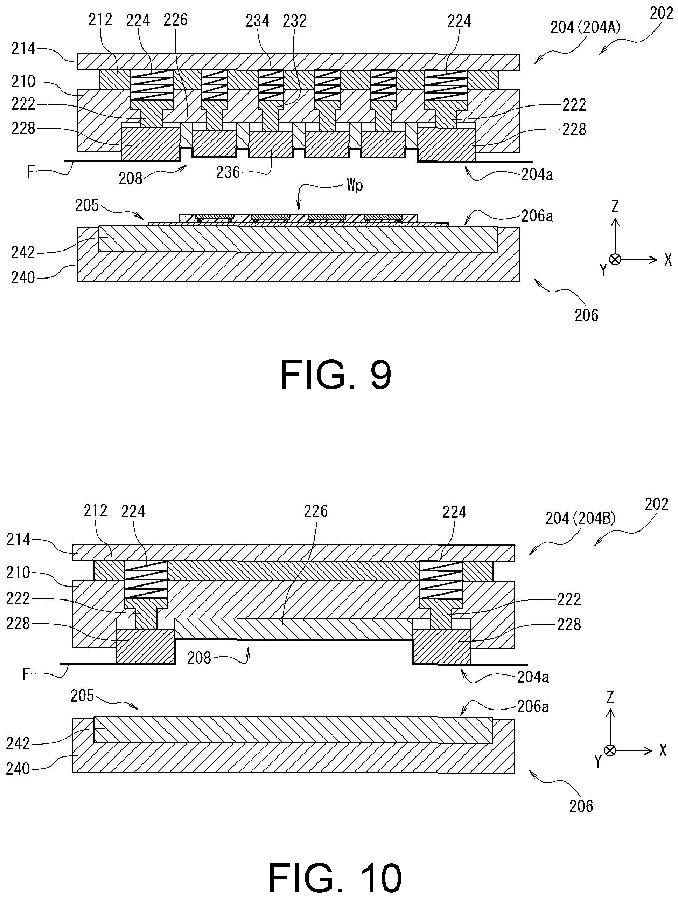

As a subsequent process following the mold closing process described above, a mold opening process is performed in which mold opening of the sealing mold 202 is performed, the molded product Wp and the used film F are separated, and the molded product Wp can be taken out (see FIG. 9). In the embodiment, since resin sealing is performed in a state where the movable piece 236 covers the upper surface Wbf (entire surface) of the electronic part Wb of the workpiece W, thin burrs are prevented from forming on the upper surface Wbf of the electronic part Wb, and the molded product Wp is formed in a state where the upper surface Wbf (entire surface) is reliably exposed. As a modification example, it is also possible to set a partial region rather than the entire upper surface Wbf of the electronic part Wb as an exposed portion (not shown). Additionally, it is also possible to set a partial region of the base material Wa as an exposed portion and mount the electronic part Wb on the exposed portion after resin sealing (not shown).

After the mold opening process, a molded product unloading process is performed in which the molded product Wp is unloaded from the inside of the sealing mold 202 by the second loader 24 and transported to the storage unit 10C. As an example, the transported molded product Wp is stored in the storage magazine 18. Additionally, after the molded product unloading process, or in parallel therewith, a process is performed in which the film supply mechanism 211 is operated to send out the used film F from the inside of the sealing mold 202 and send and set a new film F into the sealing mold 202.

The above are the main processes of the compression molding method performed by using the compression molding device 1 including the sealing mold 202. However, the order of processes is an example, and it is possible to change the order or perform the processes in parallel as long as there is no hindrance.

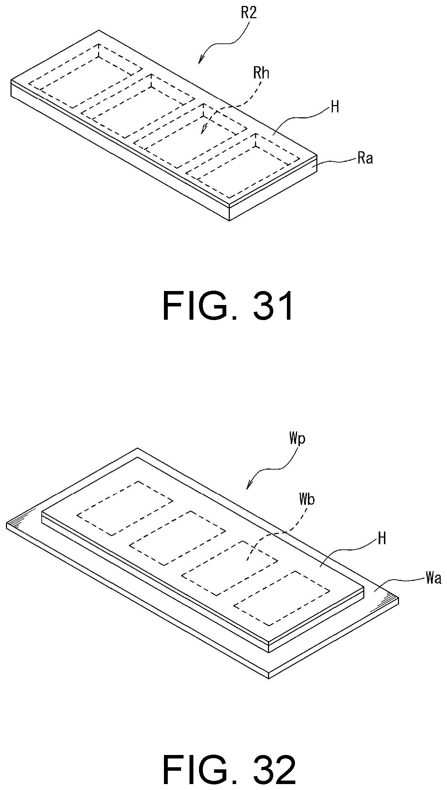

As another example, compression molding of the workpiece W can also be performed by using the sealing resin R (hereinafter, may be referred to as "R2" for distinction) having a different configuration. Specifically, the sealing resin R (R2) has a lattice shape having the through holes Rh, and a heat dissipation plate H is fixed to one surface side so that (all or some of) the through holes Rh are blocked (see FIG. 31). As an example, the heat dissipation plate H is a plate-shaped member formed with a thickness dimension of approximately 0.1 mm to several mm by using a metal material (for example, copper alloy, aluminum alloy, etc.). However, the invention is not limited thereto. By performing resin sealing (compression molding) using the sealing resin R (R2), the molded product Wp having a configuration in which the heat dissipation plate H is exposed on the upper surface (see FIG. 32) can be easily formed (details of the forming method will be described later).

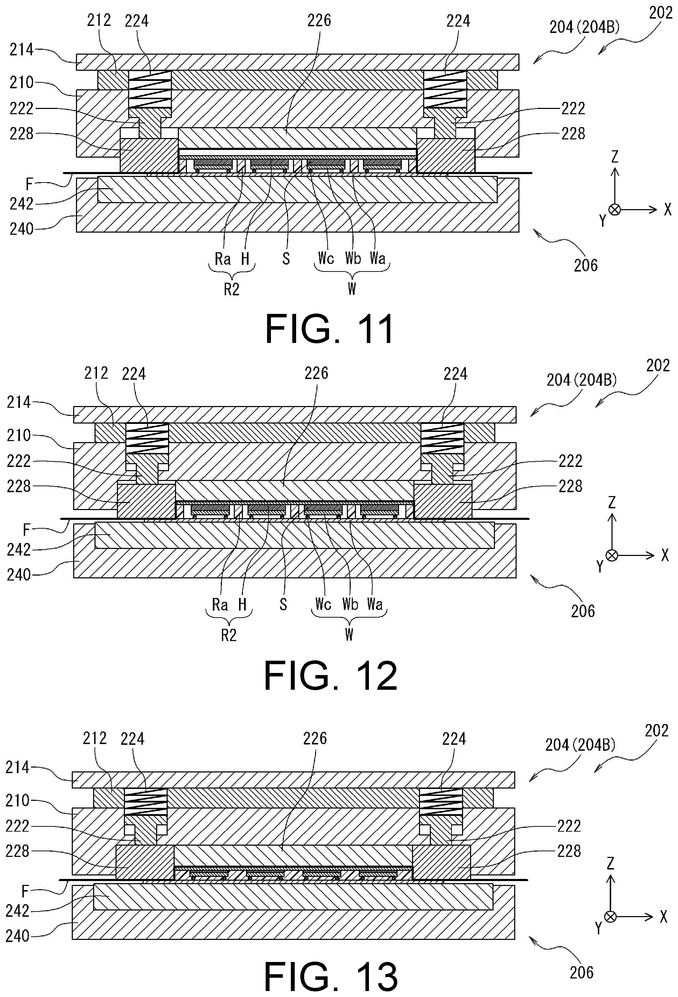

In the case of forming the molded product Wp in which the heat dissipation plate H is exposed by using the sealing resin R (R2), as the first mold 204, instead of the first mold 204A having the movable piece 236 (see FIG. 3), a first mold 204B having a general configuration without a movable piece (see FIG. 10) may be used. The processes of the compression molding method performed in this case will be described with reference to FIG. 11 to FIG. 14.

First, as the preparation process, the upper mold heating process, the lower mold heating process, and the film supply process are performed.

After the preparation process, the workpiece holding process is performed in which the workpiece W is held by the workpiece holding part 205 of the second mold 206.

After the workpiece holding process, the resin placement process is performed in which the sealing resin R (R2) is placed on the workpiece W held by the workpiece holding part 205. Alternatively, as another example of the resin placement process, it may be performed as a process of placing the sealing resin R (R2) on the workpiece W before the workpiece holding process. By using the sealing resin R2, since there is no need to carry the sealing resin R and the heat dissipation plate H separately into the sealing mold 202 (that is, the sealing resin R and the heat dissipation plate H can be carried in as one member in one process), the process can be simplified and the time can be reduced.

After the resin placement process, the mold closing process is performed in which the workpiece W is sealed with the sealing resin R (R2) and processed into the molded product Wp. Specifically, an operation of bringing the first mold 204 (204B) and the second mold 206 closer to each other is performed. At this time, the clamper 228 comes into contact with the base material Wa of the workpiece W via the film F and clamps the workpiece W (see FIG. 11). Next, the lower surface of the cavity piece 226 comes into contact with the upper surface of the heat dissipation plate H of the sealing resin R (R2) placed on the base material Wa of the workpiece W and covers the entire surface of the heat dissipation plate H (see FIG. 12). The processes may also be set to occur simultaneously. Next, the lower surface of the heat dissipation plate H in contact with the cavity piece 226 pressurizes the sealing resin R (R2) placed on the base material Wa of the workpiece W. As a result, the sealing resin R (R2) is thermoset and resin sealing (compression molding) is completed (see FIG. 13). Although this example uses the sealing resin R2 with the heat dissipation plate H having the shape of FIG. 31, but it does not necessarily have to include the heat dissipation plate H. In such case, the same molding can be achieved by performing the workpiece holding process, then performing the resin placement process of placing the sealing resin R1 without the heat dissipation plate having the shape of FIG. 29 on the workpiece W, then performing the heat dissipation plate placement process of placing the heat dissipation plate H on the sealing resin R1, and then performing the mold closing process.

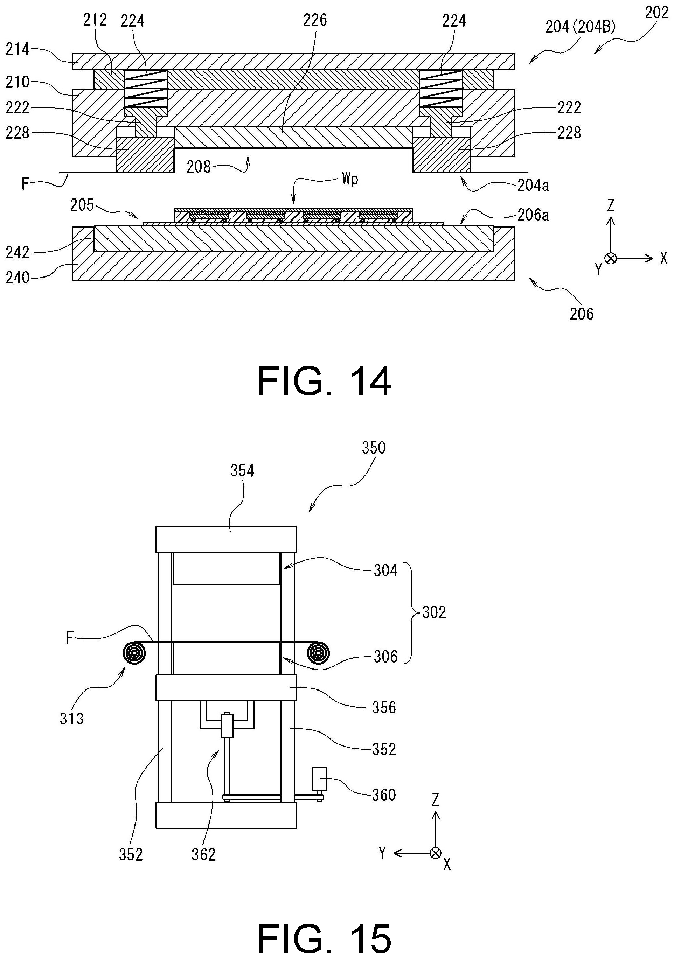

As a subsequent process following the mold closing process, the mold opening process is performed in which the sealing mold 202 is opened, and the molded product Wp and the used film F are separated so that the molded product Wp can be taken out (see FIG. 14). As described above, since resin sealing is performed in a state where the cavity piece 226 covers the upper surface (entire surface) of the heat dissipation plate H of the sealing resin R (R2), thin burrs on the upper surface of the heat dissipation plate H are prevented from being formed, and a molded product Wp (see FIG. 32) in which the upper surface (entire surface) is reliably exposed is formed.

Here, an elastic thermal conductive resin sheet S may be arranged between a surface of the electronic part Wb mounted on the workpiece W opposite to the heat dissipation plate H and a surface of the heat dissipation plate H of the sealing resin R (R2) placed on the workpiece opposite to the electronic part Wb. This makes it possible to fill the gap between the electronic part Wb and the heat dissipation plate H and prevent the upper surface of the electronic part Wb from being resin sealed. Additionally, the sealing resin R (R2) can be pressed down and pressurized through the heat dissipation plate H, and the clamping force during mold closing can be absorbed to prevent the electronic part Wb from being damaged. The elastic thermal conductive resin sheet S may be provided (as an example, attached) to the workpiece W (electronic part Wb) in advance, or an elastic thermal conductive resin sheet supply part may be provided within the device (as an example, the supply unit 10A) to supply it onto the workpiece W (electronic part Wb) before resin sealing (not shown).

After the mold opening process, the molded product unloading process is performed in which the molded product Wp is unloaded from inside the sealing mold 202 by the second loader 24 and transported to the storage unit 10C. Additionally, after the molded product unloading process, or in parallel therewith, a process is performed in which the film supply mechanism 211 is operated to send out the used film F from the inside of the sealing mold 202 and send and set the new film F into the sealing mold 202.

### [Second Embodiment]

Subsequently, a second embodiment of the invention will be described. The compression molding device 1 and the compression molding method according to the embodiment have the same basic configuration as the first embodiment, but have differences in the configuration of the press unit 10B (particularly, the configuration of the press device and the sealing mold), as well as in the processes performed mainly in the press unit 10B. Hereinafter, the embodiment will be described focusing on the differences.

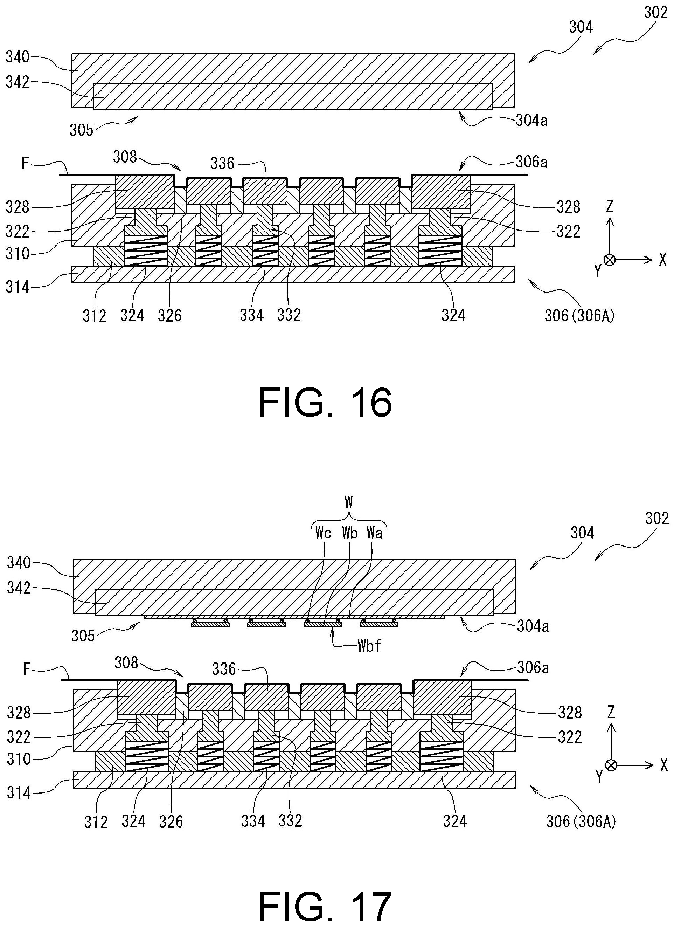

The press unit 10B the press unit 10B according to the embodiment includes a sealing mold 302 having a pair of molds that are opened and closed (for example, multiple mold blocks, mold plates, mold pillars, and other members assembled together, which are made of alloy tool steel). Additionally, the press unit 10B includes a press device 350 that drives the sealing mold 302 to open and close to perform resin sealing of the workpiece W. As an example, a configuration including one press device 350 is adopted, but a configuration including multiple press devices may also be adopted (not shown). A side view (schematic view) of the press device 350 provided in the press unit 10B is shown in FIG. 15, and a front cross-sectional view (schematic view) of the sealing mold 302 is shown in FIG. 16.

Here, as shown in FIG. 16, the press device 350 is configured to include a pair of platens 354, 356, multiple tie bars 352 on which the pair of platens 354, 356 are installed, and a drive device that moves (raises and lowers) the platen 356. Specifically, the drive device is configured to include a drive source (for example, an electric motor) 360 and a drive transmission mechanism (for example, a ball screw or toggle link mechanism) 362 (however, the invention is not limited thereto). In the embodiment, the platen 354 on the upper side in the vertical direction is set as a fixed platen (a platen fixed to the tie bars 352), and the platen 356 on the lower side is set as a movable platen (a platen slidably held by the tie bars 352 and raised and lowered). However, the invention is not limited thereto, and the arrangement may be reversed, that is, the upper side may be set as a movable platen and the lower side may be set as a fixed platen, or both the upper side and the lower side may be set as movable platens (none of which are shown).

On the other hand, as shown in FIG. 16, the sealing mold 302 includes a first mold (lower mold) 306 and a second mold (upper mold) 304 as a pair of molds arranged between the pair of platens 354, 356 in the press device 350. The upper mold 304 is assembled to the platen on the upper side (in the embodiment, the fixed platen 354), and the lower mold 306 is assembled to the platen on the lower side (in the embodiment, the movable platen 356). Mold closing and mold opening are performed by the upper mold 304 and the lower mold 306 approaching and separating from each other (the vertical direction (upper-lower direction) is the mold opening and closing direction).

Additionally, in the embodiment, as an example, a film supply mechanism 313 is provided that transports (supplies) the roll-shaped film F into the interior of the sealing mold 302. Depending on the configuration of the workpiece W, a strip-shaped film may be used instead of a roll-shaped film F.

Next, the upper mold 304 of the sealing mold 302 will be described in detail. As shown in FIG. 16, the upper mold 304 includes a second chase 340 and a second plate 342 held by the second chase 340.

Additionally, in the embodiment, a workpiece holding part 305 is provided that holds the workpiece W at a predetermined position on the lower surface of the second plate 342. As an example, the workpiece holding part 305 includes a workpiece guide pin (not shown) and a suction path (holes, grooves, etc.) that is arranged penetrating through the second plate 342 and communicates with a suction device (not shown). Specifically, an end of the suction path leads to a mold surface 304a of the upper mold 304, and the other end is connected to a suction device arranged outside the upper mold 304. This makes it possible to drive the suction device to suction the workpiece W through the suction path and to hold the workpiece W by suctioning the workpiece W to the mold surface 304a (here, the lower surface of the second plate 342). Instead of the suction holding mechanism described above, or together with the suction holding mechanism, a configuration including holding claws that clamp the outer periphery of the workpiece W may be adopted (not shown). The shape and the number of the workpiece holding parts 305 provided in one upper mold 304 are appropriately set according to the shape and the number of the workpieces W (one or multiple).

Additionally, in the embodiment, an upper mold heating mechanism (not shown) is provided that heats the upper mold 304 to a predetermined temperature. The upper mold heating mechanism includes a heater (for example, an electric heating wire heater), a temperature sensor, a power source, and the like, and heating control is performed by the control part 90. As an example, the heater is built into the second chase 340 and is configured to apply heat to the entire upper mold 304 and the workpiece W held by the workpiece holding part 305. The upper mold 304 is heated by the heater to a predetermined temperature (for example, 100°C to 300°C).

Next, the lower mold 306 (306A) of the sealing mold 302 will be described in detail. As shown in FIG. 16, the lower mold 306 (306A) includes a first chase 310 and a cavity piece 326, a clamper 328, and the like held by the first chase 310. The first chase 310 is fixed to the lower surface of the support plate 314 via the support pillar 312. A cavity 308 is provided on the upper surface (the surface on the side of the upper mold 304) of the lower mold 306 (306A).

The clamper 328 is configured in an annular shape to surround the cavity piece 326, and is assembled to be movable up and down while being spaced apart (floating) from the lower surface of the support plate 314 via a push pin 322 and a clamper spring (for example, a biasing member exemplified by a coil spring) 324 (however, the invention is not limited to the assembly structure). The cavity piece 326 constitutes the inner part (bottom) of the cavity 308, and the clamper 328 constitutes the side part of the cavity 308. The shape and the number of the cavities 308 provided in one lower mold 306 (306A) are appropriately set according to the shape and the number of the workpieces W (one or multiple).

Here, a movable piece 336 is provided on the cavity piece 326 (the inner side of the cavity 308) at a position corresponding to the through hole Rh of the sealing resin R (R1) held by the workpiece holding part 305. The movable piece 336 is supported in a state of being biased toward the upper mold 304 by a movable piece spring 334 via a push pin 332, and is configured to be movable in the mold opening and closing direction. Additionally, as an example, the movable piece 336 is set to have an outer diameter that is larger than the outer shape of the electronic part Wb by a predetermined dimension in plan view. That is, the movable piece 336 is configured to enter the through hole Rh of the sealing resin R (R1) and contact the entire upper surface Wbf of the electronic part Wb during mold closing. This allows forming the molded product Wp in which the upper surface Wbf of the electronic part Wb is exposed.

Additionally, suction paths (holes, grooves, and the like) communicating with a suction device are provided on the upper surface of the clamper 328, at the boundary between the clamper 328 and the cavity piece 326, and the like (not shown). This allows the film F supplied from the film supply mechanism 313 to be adsorbed and held on the mold surface 306a including the inner surface of the cavity 308. Additionally, degassing inside the cavity 308 can be performed at the time when mold closing is performed to carry out resin sealing.

Additionally, in the embodiment, a lower mold heating mechanism (not shown) that heats the lower mold 306 (306A) to a predetermined temperature is provided. The lower mold heating mechanism includes a heater (for example, an electric heating wire heater), a temperature sensor, a power source, and the like, and heating control is performed by the control part 90. As an example, the heater is built into the first chase 310 and is configured to apply heat to the entire lower mold 306 (306A) and the sealing resin R accommodated in the cavity 308. The lower mold 306 (306A) is heated by the heater to a predetermined temperature (for example, 100°C to 300°C).

Next, the processes of the compression molding method according to the embodiment carried out by using the compression molding device 1 will be described. Here, FIG. 17 to FIG. 22 are explanatory views of the respective process, and are illustrated as front cross-sectional views in the same direction as FIG. 16.

First, as the preparation process, the heating process (upper mold heating process) is carried out in which the upper mold 304 is adjusted and heated to a predetermined temperature (for example, 100°C to 300°C) by the upper mold heating mechanism. Additionally, the heating process (lower mold heating process) is carried out in which the lower mold 306 (306A) is adjusted and heated to a predetermined temperature (for example, 100°C to 300°C) by the lower mold heating mechanism. Additionally, the film supply process is carried out in which the film supply mechanism 313 is operated to supply the new film F and adsorb the new film F so as to cover a predetermined region of the mold surface 306a including the inner surface of the cavity 308 in the lower mold 306 (306A).

After the preparation process, the workpiece holding process is carried out in which the workpiece W is held by the workpiece holding part 305 of the upper mold 304 (see FIG. 17). Specifically, the workpiece W supplied from the workpiece supply magazine 12 is held by the first loader 22, transported into the sealing mold 302, and held by the workpiece holding part 305 of the second plate 342 (mold surface 304a).

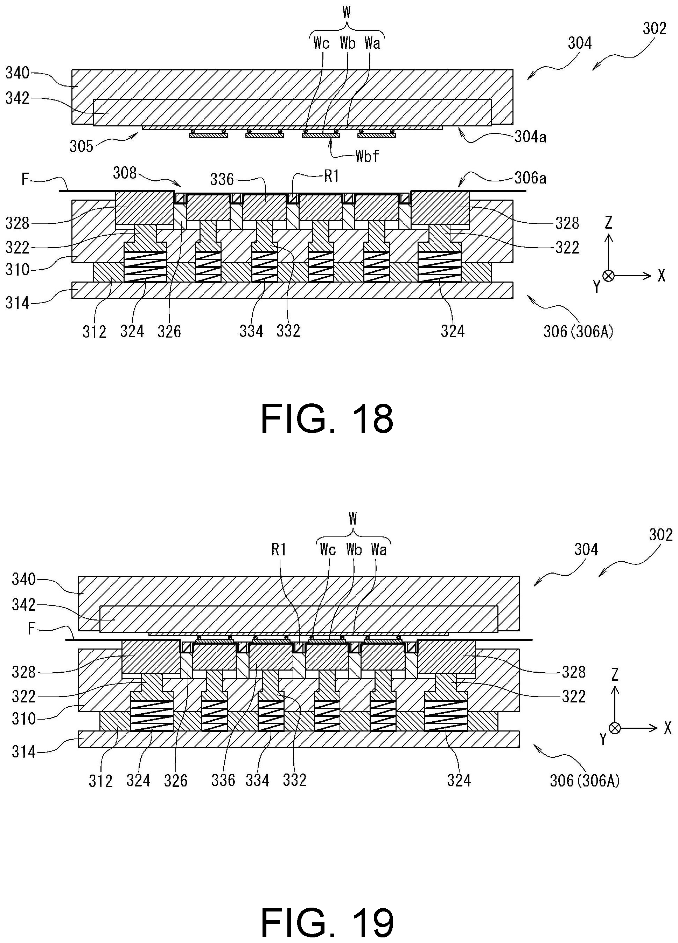

After the workpiece holding process, or in parallel therewith, the resin placement process is carried out in which the sealing resin R (R1) is placed (accommodated) in the cavity 308 of the lower mold 306 (306A) (see FIG. 18). Specifically, the sealing resin R (R1) supplied from the resin supply part 14 is held by the first loader 22 (or another transport device may be used), transported into the sealing mold 302, and accommodated in the cavity 308 of the lower mold 306 (306A) (specifically, placed on the upper surface of the cavity piece 326). In the case of forming the molded product Wp in which the upper surface Wbf of the electronic part Wb is exposed, the workpiece W and the sealing resin R (R1) are mutually aligned and placed so that the electronic part Wb is accommodated in the through hole Rh of the sealing resin R (R1).

After the resin placement process, the mold closing process is carried out in which the workpiece W is sealed with the sealing resin R (R1) and processed into the molded product Wp. Specifically, mold closing of the sealing mold 302 is performed, the cavity piece 326 is relatively lowered within the cavity 308 surrounded by the clamper 328, and the sealing resin R is heated and pressurized against the workpiece W.

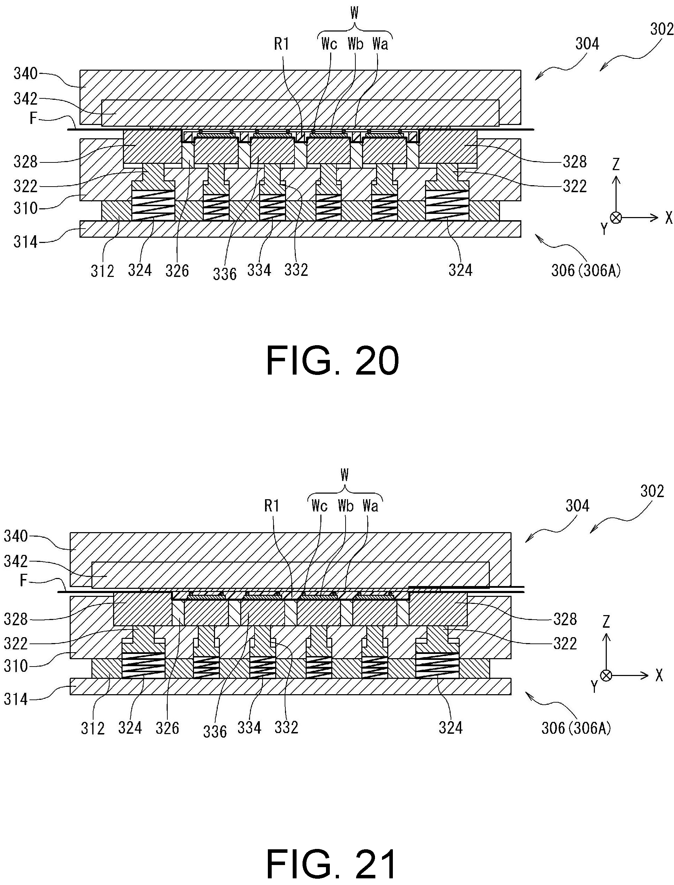

More specifically, an operation is performed to bring the upper mold 304 and the lower mold 306 (306A) closer to each other. At this time, the movable piece 336 enters the through hole Rh of the sealing resin R (R1) and comes into contact with the upper surface Wbf (in a downward-facing state) of the electronic part Wb of the workpiece W, and covers the entire upper surface Wbf (see FIG. 19). Next, the clamper 328 comes into contact with the base material Wa of the workpiece W via the film F and clamps the workpiece W (see FIG. 20). The processes may be set to occur in the reverse order or simultaneously. Next, the sealing resin R (R1) is pressurized by the upper surface of the cavity piece 326 (the region where the movable piece 336 is not provided) and the base material Wa of the workpiece W. As a result, the sealing resin R (R1) is thermoset and resin sealing (compression molding) is completed (see FIG. 21).

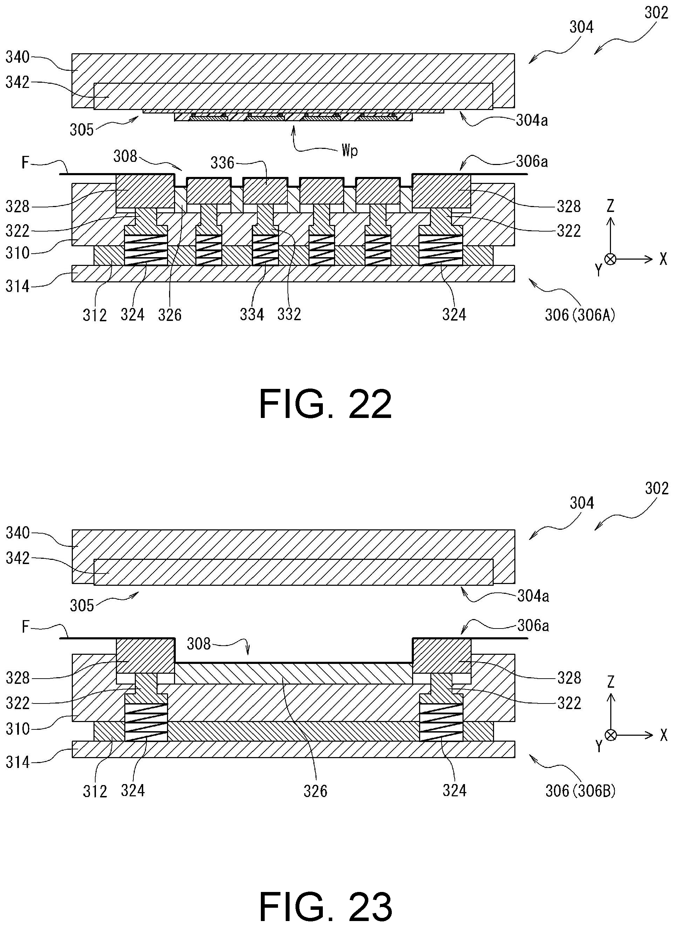

As a subsequent process following the mold closing process, the mold opening process is carried out in which mold opening of the sealing mold 302 is performed, and the molded product Wp and the used film F are separated so that the molded product Wp can be taken out (see FIG. 22). In the embodiment, as described above, resin sealing is performed in a state where the movable piece 336 covers the upper surface Wbf (entire surface) of the electronic part Wb of the workpiece W, so thin burrs on the upper surface Wbf of the electronic part Wb are prevented from being formed, and the molded product Wp is formed in which the upper surface Wbf (entire surface) is reliably exposed. As a modification example, it is also possible to set a partial region, rather than the entire upper surface Wbf of the electronic part Wb, as the exposed portion (not shown). Additionally, it is also possible to set a partial region of the base material Wa as the exposed portion and mount the electronic part Wb on the exposed portion after resin sealing (not shown).

After the mold opening process, the molded product unloading process is carried out in which the molded product Wp is unloaded from within the sealing mold 302 by the second loader 24 and transported to the storage unit 10C. As an example, the transported molded product Wp is stored in the storage magazine 18. Additionally, after the molded product unloading process, or in parallel therewith, a process is carried out in which the film supply mechanism 313 is operated to send out the used film F from the inside of the sealing mold 302 and send and set a new film F into the sealing mold 302.

The above are the main processes of the compression molding method performed by using the compression molding device 1 including the sealing mold 302. However, the above process order is an example, and changing the order or parallel implementation is possible as long as there is no hindrance.

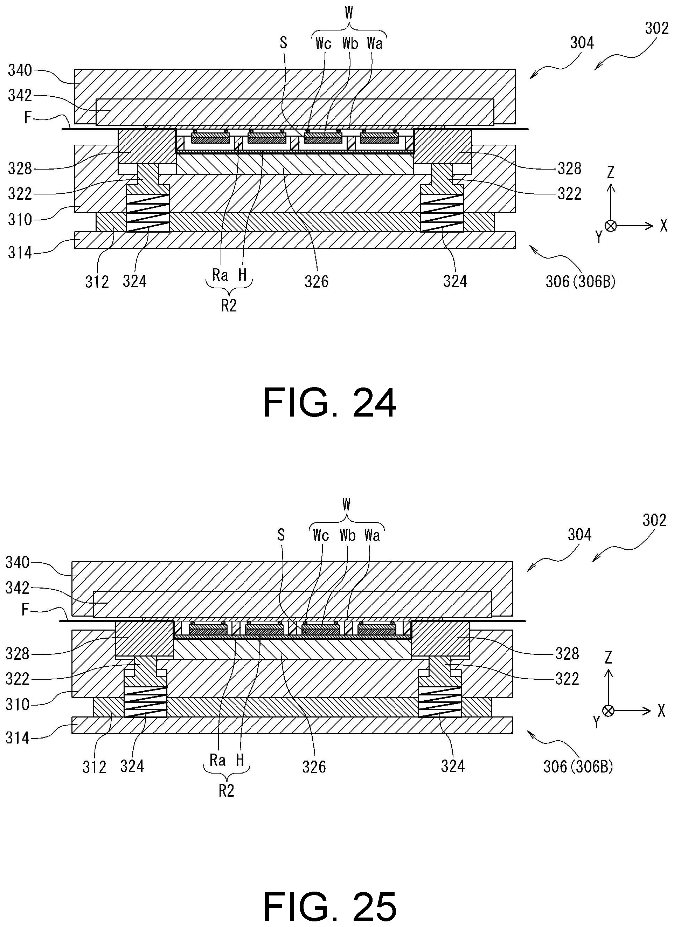

As another example, compression molding of the workpiece W can also be performed using the sealing resin R (R2) having a different configuration. In the case of forming the molded product Wp in which the heat dissipation plate H is exposed by using the sealing resin R (R2), as the lower mold 306, instead of the lower mold 306A having the movable piece 336 (see FIG. 16), a lower mold 306B having a general configuration without a movable piece (see FIG. 23) may be used. The processes of the compression molding method carried out in this case are described with reference to FIG. 24 to FIG. 27.

First, as the preparation process, the upper mold heating process, the lower mold heating process, and the film supply process are carried out.

After the preparation process, the workpiece holding process is carried out in which the workpiece W is held by the workpiece holding part 305 of the upper mold 304.

After the workpiece holding process, or in parallel therewith, the resin placement process is carried out in which the sealing resin R (R2) is placed (accommodated) in the cavity 308 of the lower mold 306 (306B). By using the sealing resin R2, there is no need to carry the sealing resin R and the heat dissipation plate H separately into the sealing mold 302 (that is, the sealing resin R and the heat dissipation plate H can be carried in as one member in one process), so the process can be simplified and time can be reduced.

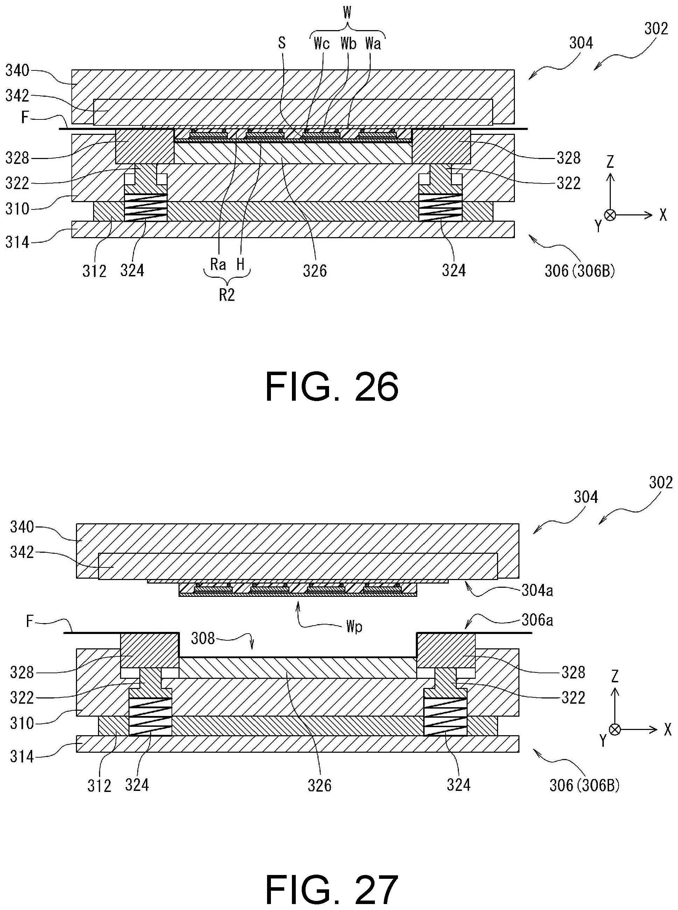

After the resin placement process, a mold closing process is carried out in which the workpiece W is sealed with the sealing resin R (R2) and processed into the molded product Wp. Specifically, an operation of bringing the upper mold 304 and the lower mold 306 (306B) closer to each other is performed. At this time, the clamper 328 comes into contact with the base material Wa of the workpiece W via the film F and clamps the workpiece W (see FIG. 24). Next, the base material Wa of the workpiece W comes into contact with the upper surface (the surface to which the heat dissipation plate H is not fixed) of the sealing resin R (R2) (see FIG. 25). The processes may be set to occur simultaneously. Next, the sealing resin R (R2) is pressurized by the heat dissipation plate H in contact with the cavity piece 326 and the base material Wa of the workpiece W. As a result, the sealing resin R (R2) is thermoset and the resin sealing (compression molding) is completed (see FIG. 26). In this example, the sealing resin R2 with the heat dissipation plate H having the shape of FIG. 31 is used, but it does not necessarily have to include the heat dissipation plate H. In that case, the workpiece holding process is carried out, then the heat dissipation plate placement process is carried out in which the heat dissipation plate H is simply placed in the cavity 308 of FIG. 23, then the resin placement process is carried out in which the sealing resin R1 without the heat dissipation plate having the shape of FIG. 29 is placed on the heat dissipation plate H, and then the mold closing process is carried out, whereby the same molding can be achieved. However, the workpiece holding process and the heat dissipation plate placement process may be carried out in reverse order or simultaneously.

As a subsequent process following the mold closing process, the mold opening process is carried out in which mold opening of the sealing mold 302 is performed, and the molded product Wp and the used film F are separated so that the molded product Wp can be taken out (see FIG. 27). As described above, since the resin sealing is performed in a state where the cavity piece 326 covers the upper surface (entire surface) of the heat dissipation plate H of the sealing resin R (R2), thin burrs on the upper surface of the heat dissipation plate H are prevented from being formed, and the molded product Wp (see FIG. 32) in which the upper surface (entire surface) is reliably exposed is formed.

Here, the elastic thermal conductive resin sheet S may be arranged between a surface of the electronic part Wb mounted on the workpiece W opposite to the heat dissipation plate H and a surface of the heat dissipation plate H of the sealing resin R (R2) placed on the workpiece opposite to the electronic part Wb. As a result, the gap between the electronic part Wb and the heat dissipation plate H can be filled, and the upper surface of the electronic part Wb can be prevented from being resin sealed. In addition, the sealing resin R (R2) can be pushed down and pressurized via the heat dissipation plate H, and the clamping force during mold closing can be absorbed to prevent the electronic part Wb from being damaged.

After the mold opening process, the molded product unloading process is carried out in which the molded product Wp is unloaded from the inside of the sealing mold 302 by the second loader 24 and transported to the storage unit 10C. In addition, after the molded product unloading process, or in parallel therewith, the process is carried out in which the film supply mechanism 313 is operated to send out the used film F from the inside of the sealing mold 302 and send and set a new film F into the sealing mold 302.

As described above, according to the forming device and the forming method according to the invention, it is possible to prevent molding defects caused by scattering unevenness, residual gas, and dust generation during molding from occurring, and it is possible to prevent thin burrs of sealing resin at exposed portions of the molded product from being formed. In addition, handling before resin sealing can be facilitated. Furthermore, if a lattice-shaped solid sealing resin with a heat dissipation plate fixed thereto is used, a molded product having a configuration in which the heat dissipation plate is exposed on the upper surface can be easily formed, and the compression molding process can be simplified and the time can be reduced.

The invention is not limited to the above embodiments, and various modifications are possible without departing from the invention.

## Claims

1. A compression molding device, sealing a workpiece with sealing resin and processing the workpiece into a molded product by using a sealing mold comprising a first mold and a second mold, one of which serves as an upper mold and an other serves as a lower mold, wherein:
the sealing resin is formed in a lattice shape having a through hole,
the first mold has a cavity configured as a recess in which a cavity piece forms a bottom part, and
the second mold has a workpiece holding part that holds the workpiece.

2. The compression molding device as claimed in claim 1, wherein the sealing resin is solid resin formed by tableting powder resin, or sheet-shaped resin.

3. The compression molding device as claimed in claim 2, wherein:
the first mold further has a movable piece that is arranged at a position corresponding to the through hole of the sealing resin on an inner side of the cavity and is movable up and down, and
when the sealing mold is closed, the movable piece enters the through hole and comes into contact with an upper surface of the workpiece.

4. The compression molding device as claimed in claim 2 or 3, wherein:
the workpiece has a configuration in which an electronic part is mounted on a base material,
the sealing resin has a configuration in which a heat dissipation plate is fixed and the through hole is blocked, and
a member having elasticity and thermal conductivity is provided between a surface of the electronic part of the workpiece opposite to the heat dissipation plate and a surface of the heat dissipation plate of the sealing resin placed on the workpiece or an inner side of the cavity opposite to the electronic part.

5. A compression molding method for sealing a workpiece with sealing resin and processing the workpiece into a molded product by using a sealing mold comprising a first mold and a second mold, one of which serves as an upper mold and an other serves as a lower mold, the compression molding method comprising:
adopting sealing resin formed in a lattice shape having a through hole as the sealing resin,
a workpiece holding process of holding the workpiece in the second mold;
a resin placement process of placing the sealing resin on the workpiece in a case where the first mold is an upper mold, and placing the sealing resin on an inner side of a cavity of the first mold in a case where the first mold is a lower mold; and
a mold closing process of performing mold closing of the sealing mold to seal the workpiece with the sealing resin and process the workpiece into the molded product.

6. The compression molding method as claimed in claim 5, wherein solid resin formed by tableting powder resin, or sheet-shaped resin is used as the sealing resin.

7. The compression molding method as claimed in claim 5 or 6, comprising:
a heat dissipation plate placement process of, in a case where the first mold is an upper mold, placing a heat dissipation plate on the sealing resin after the resin placement process, and in a case where the first mold is a lower mold, placing the heat dissipation plate on the inner side of the cavity of the first mold before the resin placement process.

8. The compression molding method as claimed in claim 6, wherein the mold closing process comprises a process in which a movable piece arranged at a position corresponding to the through hole of the sealing resin on the inner side the cavity of the first mold and movable up and down enters the through hole and comes into contact with an upper surface of the workpiece when the sealing mold is closed.

9. The compression molding method as claimed in claim 6, wherein:
a workpiece having a configuration in which an electronic part is mounted on a base material is used as the workpiece,
sealing resin having a configuration in which a heat dissipation plate is fixed and the through hole is blocked is used as the sealing resin, and
a member having elasticity and thermal conductivity is provided between a surface of the electronic part of the workpiece opposite to the heat dissipation plate and a surface of the heat dissipation plate of the sealing resin placed on the workpiece or the inner side of the cavity opposite to the electronic part.
